# EUROPÄISCHE PATENTSCHRIFT

(11) **EP 3 428 667 B1**
(45) Veröffentlichungstag und Bekanntmachung des Hinweises auf die Patenterteilung: **27.07.2022**
(21) Anmeldenummer: 18186091.7
(22) Anmeldetag: 30.06.2015
(51) Int. Cl.: G01R 31/34, H02P 29/02, G01R 19/165, H02P 29/024, H02M 1/32

(54) **VERFAHREN ZUR ERLANGUNG EINES HINWEISES, INSBESONDERE EINES ANFANGSHINWEISES AUF EINE MÖGLICHE FEHLERHAFTE LASTBEDINGUNG EINES MEHRPHASIGEN ELEKTROMOTORS**
METHOD FOR OBTAINING AN INDICATION, IN PARTICULAR AN INITIAL INDICATION OF A POSSIBLE FAULTY LOAD CONDITION OF A POLYPHASE ELECTRIC MOTOR
PROCÉDÉ D'OBTENTION D'UNE INSTRUCTION, EN PARTICULIER D'UNE INSTRUCTION INITIALE SUR UNE CONDITION DE CHARGE POSSIBLE ERRONÉE D'UN MOTEUR ÉLECTRIQUE MULTIPHASE

(30) Priorität: 30.06.2014 DE 102014212572; 30.06.2014 DE 102014212586; 30.06.2014 DE 102014212626
(43) Veröffentlichungstag der Anmeldung: 16.01.2019
(62) Teilanmeldung aus: 15733434.3
(73) Patentinhaber: Elmos Semiconductor SE, 44227 Dortmund (DE)
(72) Erfinder: Hartzsch, Jörg, 44227 Dortmund (DE)
(74) Vertreter: dompatent von Kreisler Selting Werner - Partnerschaft von Patent- und Rechtsanwälten mbB

(56) Entgegenhaltungen:
- EP-A2- 1 136 828
- DE-A1-102008 052 933
- DE-A1-102011 003 897
- DE-A1-102011 004 911
- JOHNSON J P ET AL: "Review of sensorless methods for brushless DC", CONFERENCE RECORD OF THE 1999 IEEE INDUSTRY APPLICATIONS CONFERENCE. THIRTY-FORTH IAS ANNUAL MEETING (CAT. NO.99CH36370), IEEE, IEEE PISCATAWAY, NJ, USA, Bd. 1, 3. Oktober 1999 (1999-10-03), Seiten 143-150, XP010355155, DOI: 10.1109/IAS.1999.799944 ISBN: 978-0-7803-5589-7

## Beschreibung

Die Erfindung betrifft ein Verfahren zur Erlangung eines Hinweises, insbesondere eines Anfangshinweises auf eine mögliche fehlerhafte Lastbedingung eines mehrphasigen Elektromotors.

Fehlerhafte Lastbedingungen bei Elektromotoren sind insbesondere dann kritisch, wenn Kurzschlüsse auftreten. Derartige Kurzschlüsse werden üblicherweise anhand der Spannungsabfälle über den Drain-Source-Strecken der internen oder externen Treiber-Transistoren der Ansteuereinheit erkannt, über die Elektromotore oder andere Lasten angesteuert werden. Diese Spannungsabfälle werden im Regelfall einzeln, d.h. pro Phase des Motors, bewertet. Wenn ein messtechnisch erfasster Strom höher als der größte in Betrieb zulässige Strom ist, deutet dies auf einen externen Kurzschluss von mindestens einer der Motoranschlussleitungen hin. Ein Nachteil bei der Detektion von Kurzschlüssen ist, dass insbesondere "weiche" Kurzschlüsse nach Masse nicht unbedingt erkannt werden können. Ein weiteres Problem besteht darin, dass der Überstrom bei relativ hochohmigen Kurzschlüssen oder bei Kurzschlüssen mit induktivem Beiwert des Kurzschlussstroms teilweise nicht außerhalb des größten, im Betrieb des Motors zulässigen Stroms liegt. Auch ist es bei induktiven Beiwerten und bei PWM-Ansteuerungen von Lasten, wie z.B. Elektromotoren, möglich, dass die Stromzunahme im Kurzschlussfall so langsam ist ("weicher" Kurzschluss), dass ein PWM-Zyklus vor Erreichen der Überstrom-Abschaltschwelle beendet ist. Die Leistungstransistoren aber können sich in derartigen Fällen dennoch derart stark aufheizen, dass es zu Schädigungen kommen kann, die so schnell auftreten, dass auch eine Übertemperaturerkennung wegen ihres Zeitverzuges keinen ausreichenden Schutz bietet.

Die Überwachung eines elektrischen Motors mit dem Ziel der Erkennung eines Fehlers ist z.B. aus DE-A-10 2011 003 897 und DE-T-697 21 455 bekannt.

Aus DE-A-10 2011 004 911 ist ein Verfahren zum Betrieb eines bürstenlosen Elektromotors bekannt, bei dem die gemessenen oder berechneten Stromverläufe der Wicklungen dahingehend untersucht werden, ob ein erhöhter ohmscher Widerstand erkannt wird.

Aufgabe der Erfindung ist es daher, eine Erkennung von fehlerhaften Lastbedingungen wie z.B. Kurzschlüssen zu schaffen, die in der Lage ist, solche Situationen zuverlässig aufzudecken und somit die Applikation, d.h. die von den Treiber-Transistoren angesteuerte Hardware vor einer Schädigung zu schützen, was darauf hinausläuft, dass z.B. bislang nicht in allen Fällen zu vermeidende Brände der Elektronik nun zuverlässig verhindert werden können.

Zur Lösung dieser Aufgabe wird mit der Erfindung ein Verfahren nach Anspruch 1 vorgeschlagen. Die Gegenstände der Unteransprüche 2 bis 11 betreffen einzelne Ausgestaltungen der Erfindung.

Erfindungsgemäß wird also ein Verfahren zur Erlangung eines Hinweises, insbesondere Anfangshinweises auf eine mögliche fehlerhafte Lastbedingung eines mehrphasigen Elektromotors mit elektrischer Kommutierung (z.B. BLDC-, EC-, PMSM- , SR-, Steppermotoren) mit einer elektrischen Ansteuereinheit, die pro Motorphase einen Highside-Schalter und einen Lowside-Schalter aufweist, wobei die Highside- und die Lowside-Schalter der Motorphasen zyklisch geschaltet werden, und zwar gemäß einem Schaltschema, das pro Motorphase mindestens einen zyklisch wiederkehrenden äquivalenten Zeitpunkt aufweist, wobei diese äquivalenten Zeitpunkte zwischen den einzelnen Motorphasen einen gleichen zeitlichen Phasenversatz aufweisen (z.B. beträgt bei 3-phasigen Motoren technisch bedingt der Phasenversatz 120° und bei 4-phasigen Motoren 90°), und wobei zu diesen Zeitpunkten jeweils die Größe des Stroms in der betreffenden Motorphase jeweils in einem im Wesentlichen gleichen Verhältnis zu den Größen der Ströme in den anderen Motorphasen zu den ihnen zugehörigen äquivalenten Zeitpunkten steht, vorgeschlagen, wobei bei dem Verfahren
- für zumindest zwei Motorphasen zu den zyklisch wiederkehrenden äquivalenten Zeitpunkten des Schaltschemas ein die Größe des Stroms in der betreffenden Motorphase repräsentierender Messwert ermittelt wird und dieser Vorgang sich zyklisch wiederholend durchgeführt wird,
- die ermittelten Messwerte der Motorphasen zumindest paarweise miteinander verglichen werden, wobei jeder Vergleich der Messwerte dahingehend überprüft wird, ob sich das Ergebnis des Vergleiches innerhalb eines hinsichtlich der zu vergleichenden Motorphasen für fehlerfreie Lastbedingungen geltenden Erwartungsraumes befindet und wobei
   - eine Abweichung des Ergebnisses des Vergleiches vom zugehörigen Erwartungsraum insbesondere unter Berücksichtigung einer vorgebbaren zulässigen Toleranz als ein Hinweis, insbesondere als Anfangshinweis auf eine fehlerbehaftete Lastbedingung gewertet wird, wie z.B. Wackelkontakt, mechanische Fehler, Lagerspiel, Getriebefehler, mechanische Fehler in der Applikation, wobei die Wiederholrate gleichartiger sequentiell auftretender Abweichungen Aussage über den Fehlerort geben kann,
      und/oder
   - bedarfsweise auch die Analyse der Stromwerte mindestens einer einzigen Motorphase zu den äquivalenten Zeitpunkten für sich in sequentieller Abfolge durchgeführt und ein Abweichen der Ergebnisse der Vergleiche vom Erwartungsraum, insbesondere unter Berücksichtigung einer vorgebbaren zulässigen Toleranz, als ein Hinweis, insbesondere als Anfangshinweis auf eine fehlerbehaftete Lastbedingung gewertet wird, wie z.B. Wackelkontakt, mechanische Fehler, Lagerspiel, Getriebefehler, mechanische Fehler in der Applikation, wobei die Wiederholrate gleichartiger sequentiell auftretender Abweichungen Aussage über den Fehlerort geben kann.

Ferner ist erfindungsgemäß vorgesehen, dass den Highside-Schaltern von zumindest zwei Motorphasen eine Highside-Überwachungseinheit zur Überwachung der Drain-Source-Spannungsabfälle der Highside-Schalter und/oder den Lowside-Schaltern von zumindest zwei Motorphasen eine Lowside-Überwachungseinheit zur Überwachung der Drain-Source-Spannungsabfälle der Low-side-Schalter zugeordnet ist und das jede Überwachungseinheit zur Ermittlung eines Messwertes verwendet wird, der die Größe des Stroms in einer Motorphase repräsentiert.

Desweiteren ist nach der Erfindung vorgesehen, dass jede der Überwachungseinheiten einen Komparator und einen Digital-Analog-Konverter zur Vorgabe eines Referenzwerts als Spannungsabfall-Schwellwert zur Detektion eines Überstromes in einem Highside- und/oder Lowside-Schalter für den Komparator aufweist und dass dieser Referenzwert moduliert wird, um einen die Größe des aktuellen Stroms repräsentierenden Messwerte mittels Auswertung des Komparators zu ermitteln, wobei ein während der Ermittlung des Messwerts auftretendes Ansprechen des Komparators nicht direkt als Überstrom gewertet wird, sondern in diesem Fall die Ermittlung des Messwerts abgeschlossen wird und im Anschluss die Referenz des Digital-Analog-Konverters auf den eigentlichen Überstromwert geschaltet wird und nachfolgend eine tatsächliche Bewertung, ob eine Überstromsituation aufgetreten ist, durchgeführt wird.

Bei dem erfindungsgemäßen Verfahren werden zu bestimmten zyklische wiederkehrenden, d.h. äquivalenten Zeitpunkten eines Motorbestromungsschemas innerhalb einer Motorphase oder motorphasenübergreifend die jeweils fließenden Ströme ermittelt. Die so ermittelten Stromwerte werden dann miteinander verglichen bzw. ins Verhältnis zueinander gesetzt, wobei hier auch wiederum lediglich die Stromwerte pro Phase oder aber phasenübergreifend betrachtet werden. Der Vergleich der Stromwerte bzw. die Verhältnisbildung der Stromwerte führt zu einem Ergebnis, das innerhalb eines gegebenenfalls zuvor definierten Erwartungswertbereichs oder aber innerhalb eines Erwartungswertbereichs liegt, der empirisch bzw. durch Bemusterung eines Elektromotors zuvor ermittelt worden ist. Weicht das Ergebnis des Vergleichs bzw. der Verhältnisbildung der Stromwerte von diesem Erwartungswertbereich ab, so ist dies als Hinweis bzw. Anfangshinweis auf eine mögliche fehlerhafte Lastbedingung des Elektromotors anzusehen. Ausgehend davon kann nun applikationsabhängig verfahren werden, indem beispielsweise eine Warnung ausgesprochen wird oder aber eine Zwangsabschaltung des Elektromotors erfolgt. Die sich an die Detektion eines Hinweises auf eine fehlerhafte Lastbedingung des Elektromotors anschließende Prozedur ist nicht notwendigerweise Gegenstand der Erfindung.

Gegenüber dem Stand der Technik ergibt sich unter Verwendung des erfindungsgemäßen Verfahrens eine höhere Erkennungssicherheit auf fehlerhafte Lastbedingungen durch verbesserte Nutzsignale und eine verbesserte Performance des Detektionsverfahrens. Die Erkennungsschwelle für das Vorliegen einer fehlerhaften Lastbedingung (z.B. Kurzschluss) ist nicht mehr abhängig von der Größe des maximal im Betrieb zulässigen Stroms. Außerdem ist eine günstige Implementierung des erfindungsgemäßen Verfahrens möglich.

Die Erfindung ist insbesondere vor dem Hintergrund zu sehen, dass für die Ansteuerung mehrphasiger Elektromotoren oder anderer induktiver Lasten in zunehmendem Maße niederohmige Leistungstransistoren eingesetzt werden. Diese Leistungstransistoren sind derart preisgünstig herstellbar, dass ihre Gesamtkosten für das Gesamtsystem geringer sind als wenn man z.B. mit einem Kühlkörper zur Kühlung konventioneller Leistungstreiber arbeiten würde, die einen höheren R_{SDON} aufweisen. Ein weiterer Vorteil des Einsatzes moderner niederohmiger Leistungstransistoren ist in dem vereinfachten Verbau der Elektronik auf Grund der geringeren Verlustleistung dieser Leistungstransistoren zu sehen. Außerdem reduziert sich in der Gesamtenergiebilanz betrachtet der CO₂-Ausstoß. Allerdings sind durch die niederohmigen Leistungstransistoren die Spannungsabfälle im Kurzschlussfall wegen des niedrigen R_{SDON} derart klein, dass ein Kurzschlussfall mit bisherigen Mitteln nicht mehr sicher detektiert werden kann. Man arbeitet daher mit deutlich empfindlicheren Kurzschlussschwellen, um den geänderten Anforderungen infolge niederohmiger Leistungstransistoren begegnen zu können. Hierbei handelt es sich allerdings um Lösungen des Problems, die nicht alle Kurzschlussfälle zu erkennen vermögen. Insbesondere im Hinblick auf BLDC- und DC-Brückentreiber-ICs sowie Steppermotor-Treiber-ICs hat der erfindungsgemäße Ansatz klare Vorteile, indem er sich auf Grund der großen Nachfrage derartiger Treiber-ICs schnell durchsetzen würde.

Wie sich aus dem Vorstehenden ergibt, ist es nicht ausreichend, die Ströme bzw. die Spannungsabfälle über den schaltenden Treibertransistoren einzeln zu überwachen. Vielmehr ist es erfindungsgemäß vorgesehen, die Ströme mehrerer und im Idealfall aller Treibertransistoren nahezu zeitgleich miteinander zu vergleichen. Dazu kann man mehrere Messeinrichtungen vorsehen, man kann aber auch aus Effektivitätsgründen eine (z.B. einzige) Messeinrichtung sequentiell nutzen. Hierbei kann man sich die Erkenntnis zunutze machen, dass sowohl der Einzelstrom als auch (gilt bei mehreren Wicklungen) der Strom aller Motorwicklungen durch die Induktivität der Wicklung keine allzu schnellen Änderungen erfahren kann. Man kann als in gewissem Rahmen zeitlich versetzt die Ströme aller beteiligten Leistungstransistoren messen (im besonderen Ausführungsfall als z.B. Spannungsabfall über den jeweiligen Leistungstransistoren) und erhält trotzdem mit nur geringer Einschränkung ein aktuelles Bild. Soweit möglich, kann man bei PWM-Ansteuerung der Treibertransistoren aber auch eine gleichzeitige oder nahezu gleichzeitige Messung der verschiedenen Motor- bzw. Lastphasen vornehmen.

Desweiteren macht sich das erfindungsgemäße Verfahren die Eigenschaft zunutze, dass in einem System aus mehrphasigem Elektromotor und Ansteuereinheit ohne zusätzlichem Kurzschluss einer oder mehrerer Motorphasen nach positivem Versorgungspotential oder Masse die Summe der Ströme aller High-side-Treiber gleich der Summe der Ströme aller Lowside-Treiber ist. Tritt hier eine Ungleichheit auf, so kann davon ausgegangen werden, dass ein Kurzschluss zu einem Potential außerhalb des Motors vorhanden ist. Das erfindungsgemäße Verfahren ist dabei anwendbar auf nahezu alle Motorentypen (Elektromotorentypen), die mit Highside- und Lowside-Treibern angesteuert werden; entsprechendes gilt für die Ansteuerung anderer induktiver Lasten als Elektromotoren.

Hinsichtlich der Strommessmethoden kann das erfindungsgemäße Verfahren unterschiedlich, und zwar entsprechend den üblichen Strommessmethoden, ausgeführt sein. So lässt sich das erfindungsgemäße Verfahren beispielsweise realisieren mit analogen Spannungsmessungen und desweiteren mit analoger oder auch digitaler Berechnung der Differenz bzw. des Vergleichs und/oder des Verhältnisses der einzelnen Stromwerte. Kompakter wird jedoch eine Umsetzung in SC-Technik sein, bei der die einzelnen Spannungen mit Vorzeichen behaftet "gestapelt" werden und die verbleibende Differenz (Vergleich) dann gegen einen Schwellwert verglichen wird. Auch hier kann ab einem geeigneten Punkt eine digitale Verarbeitung günstiger sein. Es ist auch möglich, die auf Kapazitäten gelagerten Spannungsabfälle zu entladen, die Entladezeiten digital zu messen und einer digitalen Auswertung zuzuführen. In diesem Fall erscheint die Sonderversion interessant, bei der die Entladung über geschaltete Kondensatoren erfolgt und die Anzahl der notwendigen Entladezyklen gezählt und weiterverarbeitet wird. Auf Grund der möglichen geringen Signalhöhe kann auch die Version interessant sein, bei der das Signal vor oder nach der "Stapelung" noch verstärkt wird, wobei im Spezialfall eine derartige Verstärkung so oft erfolgen kann (Spannungs-Multiplikation), bis eine bestimmte Referenzspannung erreicht ist. Die dafür notwendige Anzahl von Verstärkungszyklen kann dann als Maß für den Ergebniswert weiterverarbeitet werden. Bei einem Highside-Treiber kann diese Weiterverarbeitung direkt "oben" im Hochvolt-Bereich erfolgen, oder aber das Signal kann erst mittels einer "Spannungsspiegelung" in den Niedervolt-Bereich transferiert und dort bei Bedarf auf Kapazitäten abgelegt werden. Im letzten Fall werden dann bevorzugt bei allen Messungen die gleichen Strukturen verwendet, was zum großen Teil mögliche Offset-Fehler kompensiert. Die verbleibenden Offset-Fehler können mittels einer Referenz-Offset-Messung im unbestromten Fall kompensiert werden.

Die Erwartungswerte bzw. Erwartungswertbereiche werden zweckmäßigerweise empirisch festgelegt. Hierbei ist denkbar,
- dass die Erwartungswerte für maximal zulässige Abweichungen, bei denen noch keine fehlerhafte Lastbedingung erkannt werden soll, an einem oder mehreren vorgealterten Referenzsystemen mit fehlerfreiem Lastzustand angelernt , also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, an jedem Motorsystem für sich nach der Produktion mit fehlerfreiem Lastzustand angelernt , also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, im Laufe der Lebenszeit des Motors mit höheren Toleranzen versehen werden, und/oder
- dass die detektierte fehlerhafte Lastbedingung durch ein Abweichen des Kommutierungswinkels vom Zielbereich entsteht und dass die Ansteuereinheit den Fehler durch Anpassung zumindest eines der beiden Ansteuerparameter Amplitude und Phase kompensiert.

In einer vereinfachten Variante des erfindungsgemäßen Verfahrens kann durch alleinige Betrachtung der Lowside-Spannungsabfälle über eine komplette Ansteuerungsperiode hinweg ein Kurzschluss detektiert werden. Bei prinzipiell unverändertem Motorstrom sollte die Summe der Spannungsabfälle aller aktiven Lowside-Treiber über die Zeit hinweg gleich sein, und zwar unabhängig davon, welcher Lowside-Treiber gerade aktiv ist. Ein Kurzschluss in einem der Motorpfade sollte zu Unterschieden der Lowside-Summenströme abhängig von der Kombination der aktuell aktivierten Lowside-Treiber führen. Durch Vergleich der Einzelspannungsabfälle untereinander können zusätzlich Wicklungskurzschlüsse oder unkontaktierte Wicklungen erkannt werden. Bei entsprechender Empfindlichkeit der Messeinrichtung können die oben beschriebenen Signale auch zur Kommutierung des Motors genutzt werden. In einem alternativen Verfahren kann man die tiefpassgefilterten Einzelspannungen oder auch die tiefpassgefilterten Mittenspannungen (z.B. virtueller Sternpunkt) auf ihren konkreten Erwartungswertbereich hin überprüfen. Weicht die Spannung von dem Erwartungswertbereich signifikant ab, so ist das System durch einen Nebenschluss aus seinem "Gleichgewicht" gebracht.

In vorteilhafter Weiterbildung der Erfindung kann vorgesehen sein, dass aus der Motorphasenpaarung oder -kombination, für die eine Abweichung außerhalb des Erwartungsraumes festgestellt wird, und der Position der zugehörigen äquivalenten Zeitpunkte innerhalb des Schaltschemas auf die Art der fehlerhaften Lastbedingung geschlossen wird, für die die Abweichung als ein Hinweis, insbesondere als Anfangshinweis gewertet wird.

Ferner kann es zweckmäßig sein, wenn der der Größe des Stromes entsprechende Messwert ein elektrischer Parameter ist, und zwar z.B. ein Spannungsabfall über einem elektrischen/elektronischen Bauteil, insbesondere über einem Shunt-Widerstand oder einem Transistor, bei dem es sich insbesondere um einen Highside- und/oder einen Lowside-Schalter handelt.

Vorteilhaft kann es sein, wenn die Modifizierung des Referenzwertes beim Referenzwert zur Detektion eines Überstromes beginnt und zu geringeren Beträgen fortgesetzt wird wobei für die Bestimmung des zu ermittelnden Messwertes der Komparator nur einmal am Ende der Reduktion anspricht.

In diesem Zusammenhang kann es ferner zweckmäßig sein, wenn die Verringerung des Betrages des Referenzwertes nicht linear sondern in logarithmisch angenäherten Stufen erfolgt, in der Art, dass die prozentuale Reduktion von einem Betrag zum nächsten annähernd gleich ist.

Die Modulation des Referenzwertes kann auch gemäß einer sukzessiven Approximation erfolgen, wobei bei jedem Ansprechen des Komparators die Ermittlung des Messwertes unterbrochen wird, um temporär eine Überprüfung auf eine mögliche Überstromsituation durchzuführen.

Eine vorteilhafte Variante der Erfindung kann darin gesehen werden, dass ein detektierter Anfangshinweis auf eine mögliche fehlerhafte Lastbedingung auf zeitliche Wiederholung hin untersucht und bei zumindest zyklisch kontinuierlichem Wiederholung ab einer vorgebbaren Häufigkeit eine fehlerhafte Lastbedingung diagnostiziert wird.

In vorteilhafter Weiterbildung der Erfindung kann außerdem vorgesehen sein, dass dann, wenn bei einem fehlerfreien System mit zumindest Elektromotor und Ansteuereinheit ein zyklisch reproduzierbarer Anfangshinweis auf eine fehlerhafte Lastbedingung detektiert wird, dieser Anfangshinweis nicht auf eine tatsächliche fehlerhafte Lastbedingung, sondern auf eine elektrische und/oder mechanische Asymmetrie zwischen den Motorphasen zumindest einer der Systemkomponenten wie z.B. Ansteuereinheit und/oder Motormechanik und/oder Getriebe und/oder ein anderes vom Elektromotor angetriebenes Bauteil zurückzuführen ist, und dieses in zukünftig vorgebbaren Erwartungswertbereichen für ein fehlerfreies System berücksichtigt wird.

Schließlich kann im Bedarfsfalle auch vorgesehen sein, dass dann, wenn bei einem fehlerfreien System mit zumindest Elektromotor und Ansteuereinheit ein zyklisch reproduzierbarer Anfangshinweis auf eine fehlerhafte Lastbedingung detektiert wird, dieser Anfangshinweis nicht auf eine tatsächliche fehlerhafte Lastbedingung , sondern auf eine elektrische und/oder mechanische Asymmetrie zwischen den Motorphasen zumindest einer der Systemkomponenten wie z.B. Ansteuereinheit und/oder Motormechanik und/oder Getriebe und/oder ein anderes vom Elektromotor angetriebenes Bauteil zurückzuführen ist, und diese Asymmetrie zur Erlangung verbesserter Systemeigenschaften über eine Modifikation des Schaltschemas kompensiert wird.

In speziellen Fällen kann der Anfangshinweis auf eine fehlerhafte Lastbedingung eine Folge des Abweichens des Kommutierungswinkels von seinem Sollwert sein und es hilfreich erscheinen, dass die Ansteuereinheit den Fehler durch Anpassung zumindest eines der Ansteuerparameter Amplitude und Phase und Drehfrequenz kompensiert.

Im Falle eines dreiphasigen Elektromotors kann derjenige Zeitpunkt, zu dem zumindest an einer Motorphase der Messwert ermittelt wird, gleich dem Zeitpunkt sein, zu dem der Strom in einer anderen Motorphase (z.B. mit einem beliebigen Verfahren wie z.B. mittels BEMF Komparator) zu Null detektiert wird.

In vorteilhafter Weiterbildung der Erfindung kann vorgesehen sein, dass der den Strom repräsentierende Messwert ein Spannungsabfall (z.B. über Treiber oder Shunt-Element) ist und dass zur Ermittlung des Ergebnisses des Vergleiches zweier Messwerte Differenzen und/oder Absolutwerte von einzelnen Spannungsabfällen, auf geschalteten Kapazitäten abgelegt werden und mittels zumindest eines Verfahrens aus der Gruppe der nachfolgend genannten Verfahren behandelt und/oder ausgewertet werden: Verstärkung, Stapelung von zeitlich sequentiellen Messwerten, Vergleich, Differenzbildung, Filterung, AD-Wandlung.

In einer besonders bevorzugten Ausführungsvariante der Erfindung kann man die Stromwerte der einzelnen Motoranschlüsse in der Art sequentiell ermitteln, dass sie zu gleichen Bestromungsbedingungen, also zu bestimmten gleichen Phasenverhältnissen im Schaltschema gemessen werden. Bewertet wird dann, ob das Verhältnis der Ströme in den verschiedenen Motoranschlüssen von einem vorher ermittelten Erwartungswertbereich (bezogen auf die Verhältnisse) abweicht.

Anhand der Dauer derartiger potentiell auftretenden Abweichungen kann ermittelt werden, ob es sich um kurze Störungen (Wackelkontakt oder Störungen auf Versorgungsebene oder der Lastverhältnisse) oder um eine dauerhafte oder immer wiederkehrende fehlerhafte Lastbedingung handelt. Solche fehlerhaften Lastbedingungen können auf Dauer zur Aufheizung von Bauteilen und damit zu Schädigungen führen. Je nach Schwere der Folgen eines erkannten Fehlers wird ein Motor abgeschaltet, gedrosselt oder in einem Ausweichmodus betrieben, der eine Aufheizung durch den Fehlereinfluss verringert oder verhindert. Beispielsweise lassen sich elektrisch kommutierte Motoren auch unter Verzicht auf die Ansteuerung einzelner schaltender Bauteile betreiben.

Zwecks Klassifizieren der Abweichung des betreffenden Parameters von dem entsprechenden Erwartungswert oder -bereich können Verfahren zur statistischen Mustererkennung Anwendung finden, mit denen Betriebszustände des elektrischen (Schritt-)Motors klassifizierbar sind, um definierte Maßnahmen zur Minimierung der Auswirkung von Fehlfunktionen und zur Prognostizierung der zukünftigen Auswirkungen einer Fehlfunktion auf den Motor ergreifen zu können. Die Prognose kann dabei in Form zukünftiger möglicher Betriebszustände erfolgen, denen Wahrscheinlichkeiten und/oder Bewertungszahlen (z.B. Auswirkungsbewertungen) zugeordnet sind.

Hierbei können ein oder mehrere der nachfolgend aufgelisteten Verarbeitungsschritte durchgeführt werden:
a) Bilden eines Feature-Vektors aus mehreren Werten der Abweichungen, die gleichzeitig und/oder sequenziell festgestellt werden wobei der Feature-Vektor auf einfache und höhere Ableitungen und/oder einfache und höhere Integrale dieser Werte und/oder andere aus diesen Werten abgeleitete Größen sowie weitere Größen aus anderen Sensorsystemen umfassen kann.
b) Multiplikation eines Feature-Vektors mit einer Lineardiskriminanzanalyse-(LDA-)Matrix zu einem modifizierten Feature-Vektor zur Steigerung der Selektivität.
c) Vergleich des modifizierten Feature-Vektors mit prototypischen Vektoren, d.h. den Betriebszustandsprototypen, die insbesondere in einer Prototypendatenbank abgelegt sind, wobei das Ergebnis des Vergleiches ein binärer und/oder digitaler und/oder analoger Abstandswert zwischen dem modifizierten Feature-Vektor und dem jeweiligen prototypischen Vektor je bewertetem prototypischen Vektor ist.
d) Selektion mindestens eines Betriebszustandsprototyps der besagten Datenbank aufgrund eines Abstandswertes, wobei insbesondere der Betriebszustandsprototypen mit dem kleinsten Abstandswert und/oder der Betriebszustand mit der schwersten Auswirkung und/oder mit der schwersten Auswirkungsbewertung selektiert wird.
e) Ausgabe zumindest des selektierten Betriebszustandsprototypen.
f) Gegebenenfalls Ausgabe zumindest des Abstandswertes der dem Feature-Vektor relativ zum selektierten Betriebszustandsprototypen zugeordnet ist und/oder eines daraus abgeleiteten Wertes.
g) Gegebenenfalls Ausgabe weiterer selektierte Betriebszustandsprototypen und zugehöriger Abstandswerte und/oder daraus abgeleiteter Werte zur Ausgabe einer Hypothesenliste, die typischerweise auch den selektierten Betriebszustandsprototypen und dessen Abstandswert umfasst.
h) Gegebenenfalls Ermittlung der wahrscheinlichsten Kette von Betriebszustandsprototypen und Prognose mindestens eines folgenden prognostizierten Betriebszustandes oder einer prognostizierten Betriebszustandssequenz.
i) Gegebenenfalls Einleitung von Maßnahmen auf Grund des selektierten Betriebszustandes und/oder der ermittelten Hypothesenliste und/oder des prognostizierten Betriebszustandes oder der prognostizierten Betriebszustandssequenz.

Alternativ zu den an sich bekannten Grundverfahren der statistischen Mustererkennung können zur Verarbeitung der Abweichungen des betreffenden Parameters von dem diesem zugeordneten Erwartungswert oder -bereich neuronale Netze und/oder Petrinetze und/oder Fuzzy-Logik und/oder ein Viterbi-Algorithmus eingesetzt werden.

Gemäß der Erfindung, die für beliebige mehrphasige Motoren anwendbar ist, werden für den Fall, dass für sämtliche Motoranschlüsse einzelne Strommesseinrichtungen nicht zur Verfügung stehen, vorhandene Strommesseinrichtungen zur Ermittlung des Motorgesamtstroms genutzt. Um trotz dieser Einschränkungen eine Auswertung zu ermöglichen, ist ein spezielles, später noch zu beschreibendes Timing notwendig. Eine weitere besondere Ausprägung der Erfindung nutzt möglicherweise vorhandene Messeinrichtungen einer parametrisierbaren Überstromabschaltung, um in einer speziellen Konfiguration die beschriebene Strommessung vorzunehmen. Dabei wird ein für die Überstromabschaltung erforderlicher digitaler Referenzwert zur Messung des aktuellen Stroms moduliert, bis ein Komparator der Überstromabschaltung diese auslöst. In diesem Fall erfolgt aber keine Zwangsabschaltung der schaltenden Bauteile, sondern lediglich eine Speicherung des ermittelten digitalen Referenzwerts zum Zeitpunkt der Komparatorreaktion als aktueller Stromwert. Um während dieser Messung weiterhin bei einem niederohmigen Kurzschluss die Funktion der Überstromabschaltung gewährleisten zu können, ist es notwendig, dass sehr zeitnah nach Erreichen der Komparatorschwelle auf den "normalen" Referenzwert für die Überstromdetektion zurückgeschaltet und die Abschaltreaktion auf ein Ansprechen des Komparators reaktiviert wird. Sollte die Ansteuerung durch einen Mikroprozessor erfolgen, so ist eine ausreichend schnelle Reaktion nicht unbedingt gewährleistet. In diesem Fall sollte der digitale Referenzwert der Überstromabschaltung statisch zur Verfügung stehen und eine Logikschaltung hardwaremäßig in ausreichender Geschwindigkeit auf diesen Referenzwert umschalten können.

Die Erfindung wird nachfolgend anhand von Ausführungsbeispielen sowie unter Bezugnahme auf die Zeichnung näher erläutert. Im Einzelnen zeigen dabei:
- Fig. 1: exemplarisch eine Block-Kommutierung eines dreiphasigen Motors,
- Fig. 2: die Beschaltung eines beispielhaften dreiphasigen Motors mit dem Sonderfall, dass keine einzelnen Strommesseinrichtungen für sämtliche Motoranschlüsse vorhanden sind,
- Fig. 3: ein Beispiel eines Beschaltungsschemas (in diesem Fall für einen dreiphasigen Motor), wobei das Beschaltungsschema keine hochohmigen Phasen enthält,
- Fig. 4: Darstellungen der Auswirkungen eines Fehlerfalls auf die Strommessung im Falle eines Fehlerstroms gegen Masse,
- Fig. 5: Darstellungen der Auswirkungen eines Fehlerfalls auf die Strommessung im Falle eines Fehlerstroms gegen das positive Versorgungspotential,
- Fig. 6: eine weitere Beschaltungsoption für einen beliebigen dreiphasigen Motor mit Drain-Source-Spannungsüberwachungseinrichtungen an den Highside- und Lowside-Schaltern, wobei diese Spannungsüberwachungseinrichtungen phasenweise für die aktuelle Strommessung genutzt werden können und
- Fign. 7 und 8: schaubilderläuternde Informationen zur Beschaltungsoption nach Fig. 6 für den Fall, dass während einer Strommessung kein Kurzschluss auftritt (Fig. 7), und für den Fall, dass während einer Strommessung ein Kurzschlussfall auftritt (Fig. 8).

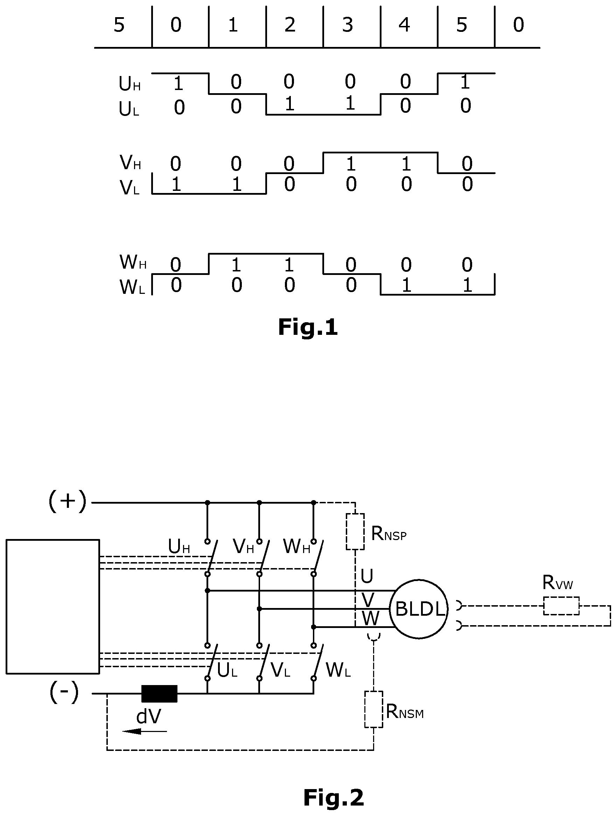

In Fig. 1 ist exemplarisch das Bestromungsschema bei einer Block-Kommutierung eines grundsätzlich beliebigen dreiphasigen Motors gezeigt. Das erfindungsgemäße Verfahren ist aber auch anwendbar bei Sinus- oder Space-Vector-Bestromung oder ähnlichen Modulationsarten und darüber hinaus auch bei anderen Motortypen wie beispielsweise bipolaren oder unipolaren Schrittmotoren.

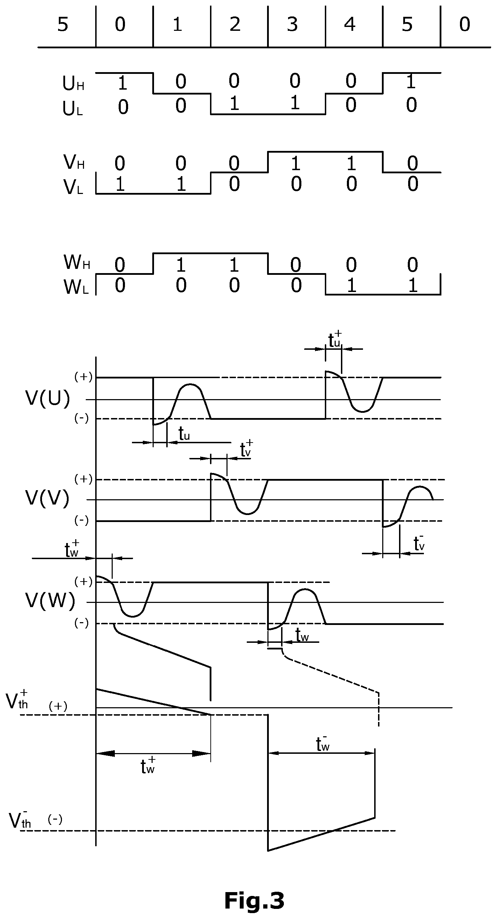

Den verschiedenen Beschaltungsschemata und Motoren ist gemeinsam, dass nach der Erfindung zu festen Phasenwinkeln (bezogen auf 360° pro elektrischer Umdrehung) der aktuelle Strom gemessen und die Strommesswerte der unterschiedlichen Anschlüsse bei gleichem individuellen Phasenwinkel des entsprechendes Anschlusses miteinander verglichen werden. Die Ströme bzw. Stromverhältnisse der verschiedenen Anschlüsse zueinander werden zu verschiedenen Zeitpunkten, in denen die zuvor festgelegten festen Phasenwinkelbeziehungen bestehen, auf reproduzierbare Abweichungen vom Erwartungswertbereich verglichen. Asymmetrisch konstruierte Motoren können z.B. zu verschiedenen Erwartungswertbereichen führen, die nicht für sämtliche Phasen gleich sind. Das erfindungsgemäße Verfahren sieht vor, diesen Effekt kompensieren zu können. Desweiteren ist vorgesehen, bei solchen Motoren die Erwartungswertbereiche auch über eine mechanische Umdrehung hinweg anzupassen, die mehrere elektrische 360°-Drehungen beinhalten kann. Damit erreicht man bei allen Motortypen eine hohe Präzision und einen Schutz vor Fehlauslösungen bei Anwendung des erfindungsgemäßen Verfahrens. In Fig. 3 sind die Ein- und Ausschaltzustände der Highside- und Lowside-Treiber U_{H}, V_{H} und W_{H} sowie U_{L}, V_{L} und W_{L} der drei Motorphasen U, V und W dargestellt. Bei der Analyse der Ströme und Stromverhältnisse mit dem erfindungsgemäßen Verfahren ergibt sich, dass
- schon geringe, dauerhafte und reproduzierbare Asymmetrien ein Anhaltspunkt für mögliche Fehlströme sind,
- temporäre Asymmetrien, die als Störungen z.B. durch Lastwechselschwankungen oder Schwankungen auf der Versorgungsebene oder durch "Wackelkontakte" entstehen, durch eine nachgeschaltete Logik von den Fehlerströmen separiert werden können, die zu einer unzulässig hohen Belastung und Schädigung der Elektronik führen können,
- sich bei Fehlstrom W nach positivem Versorgungspotential sich dV im Zustand W_{LON} erhöht und im Zustand W_{HON} dann kein Einfluss mehr vorhanden ist und
- bei Fehlstrom W nach V dV im Vergleich zu anderen Kombinationen erhöht ist, und zwar in den Zuständen W_{HON} und V_{LON} oder auch bei W_{HON} und V_{HON}.

Fig. 2 zeigt eine Beschaltungsoption für grundsätzlich beliebig ausgebildete dreiphasige Motoren für den Sonderfall, dass für keinen der Motoranschlüsse eine diesem zugeordnete einzelne Strommesseinrichtung vorhanden ist. Bei dem dreiphasigen Motor kann es sich beispielsweise um einen BLDC- oder einen Steppermotor handeln.

In Fig. 2 sind die Highside-Treiber und die Lowside-Treiber, die den drei Motorphasen U, V und W zugeordnet sind, mit U_{H}, V_{H} und W_{H} bzw. U_{L}, V_{L} und W_{L} bezeichnet. Der Motor selbst ist mit BLDC bezeichnet. Gestrichelt dargestellt sind drei potentielle Fehlstrom erzeugende Ereignisse, nämlich ein Fehlstrom erzeugender Nebenschluss der Phase W nach Masse (siehe bei R_{NSM}), ein Fehlstrom erzeugender Nebenschluss der Phase W zum positiven Versorgungspotential (siehe bei R_{NSP}) und ein Kurzschluss zwischen den Phasen V und W (siehe bei R_{VW}). Die einzige Strommesseinrichtung befindet sich in diesem Ausführungsbeispiel im Lowside-Treiberpfad und ist durch einen Shunt R_{Shunt} dargestellt. Der Shunt-Widerstand könnte aber alternativ genauso gut auch im Highside-Pfad angeordnet sein. Anstelle eines Shunt-Widerstandes kann auch jede andere Strommesseinrichtung verwendet werden. Als besonders vorteilhaft gilt es, wenn zur Strommessung der Spannungsabfall über den Treibern herangezogen wird.

Fig. 3 zeigt ein Beschaltungsschema, welches eine hochohmige Phase enthält, und zwar am Beispiel eines (beliebigen) dreiphasigen Motors. Die einzelnen Intervalle eines Schaltungszyklus sind als Phasen 0 bis 5 bezeichnet. Die High-side- und Lowside-Schalter sind wie in den vorherigen Figuren bezeichnet. Die Spannungsverläufe der drei Phasen sind mit V(U), V(V) und V(W) bezeichnet, wobei in den beiden untersten Diagrammen die entsprechend gekennzeichneten Übergangsbereiche der Spannung V(W) der Phase W vergrößert dargestellt sind.

Mögliche Zeitpunkte der Strommessung bei dieser Variante sind Zeitpunkte, bei denen durch einen Motoranschluss kein Gleichstromanteil fließt. Erfassungsoptionen solcher Zeitpunkte sind:
a) alle Erfassungszeitpunkte eines möglicherweise vorhandenen BEMF (Back EMF) Signals (siehe V(U),V(V), V(W)-Kurven von Fig. 1),
b) solange sich das Signal innerhalb der Grenzen Vₜₕ₊ und Vₜₕ₋ befindet, womit also das Erreichen der Schwelle Vₜₕ₊ oder Vₜₕ₋ als Zeitgeber genommen wird (siehe die Vergrößerungsdarstellung in den beiden untersten Diagrammen der Fig. 1),
c) zu den Zeitpunkten unter a) oder b) können geeignete Zeiten addiert werden, bevor die Messungen ausgelöst werden, wobei zu den Zeitpunkten gemäß a), b) oder c) der Strom an mindestens einem der anderen Motoranschlüsse erfasst wird.

Die Stromwerte geeigneter Phasen des Kommutierungsschemas werden miteinander verglichen. Die Differenzen oder Verhältnisse der Stromwerte zueinander werden auf reproduzierbare, sich wiederholende Abweichungen hin untersucht und wie oben beschrieben ausgewertet.

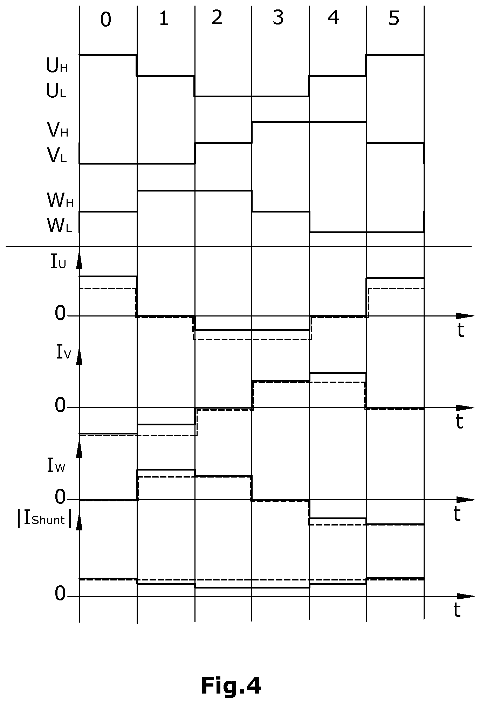

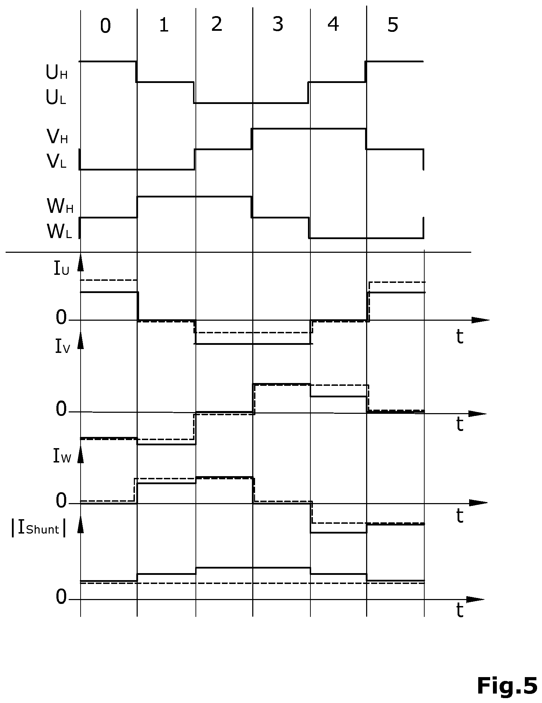

In den Fign. 4 und 5 werden unter Annahme des bereits zuvor beschriebenen Schemas der Block-Kommutierung die Auswirkungen eines Fehlerfalls auf die Strommessungen gezeigt. Dabei wird davon ausgegangen, dass für keinen der Motoranschlüsse eine gesonderte Strommesseinrichtung existiert (siehe die Situation gemäß Fig. 2). Die einzelnen Stromverläufe der Phasen U, V und W sowie über den Shunt-Widerstand sind in dem jeweiligen unteren Teil der Fign. 2 und 3 bei I_{U}, I_{V}, I_{W} bzw. I_{Shunt} gezeigt. Die Zeitpunkte, zu denen pro Phase der Strom über den Shunt-Widerstand erfasst wird, sind mit T_{Shunt} bezeichnet.

In Fig. 4 ist der Fehlerfall eines Fehlerstroms der Phase U gegen Masse gezeigt. Ohne einen derartigen Nebenschluss der Phase U gegen Masse ergibt sich in den Strommesszeiträumen und auch in den anderen Zeiträumen der jeweilige Phasenstromverlauf gemäß gestrichelter Linie, während der Nebenschluss zu einem Stromverlauf führt, wie er in Fig. 4 im unteren Teil durch eine durchgezogene Linie dargestellt ist.

Fig. 5 zeigt eine entsprechende Situation, wobei hier der Fehlerfall des Nebenschlusses der Phase U gegen das positive Versorgungspotential dargestellt ist. Ohne einen derartigen Nebenschluss ergibt sich der Stromverlauf gemäß gestrichelter Darstellung, und mit dem Nebenschlussfall ergibt sich der Stromverlauf gemäß durchgezogener Linie der Fig. 5. Mit T_{Shunt} sind wiederum die Strommesszeiträume bezeichnet.

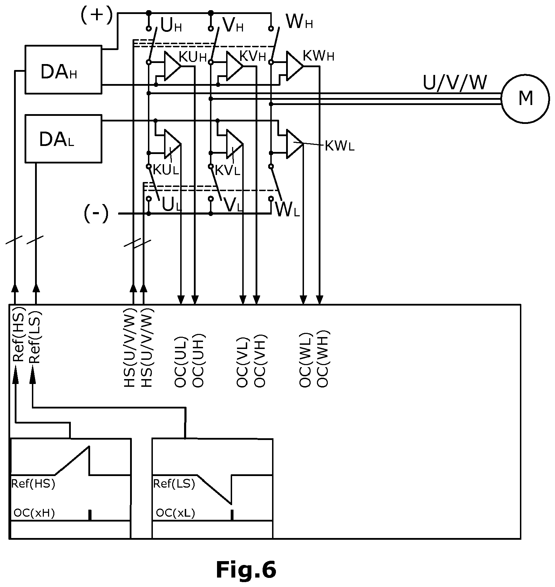

Fig. 6 zeigt den Fall einer Beschaltungsoption für einen (beliebigen) dreiphasigen Elektromotor M mit den Phasen U, V und W, bei dem für jeden Highside- und für jeden Lowside-Schalter eine Stromüberwachungseinrichtung SU vorhanden ist. Jede Stromüberwachungseinrichtung weist einen Komparator auf, der jeweils einem der Treiberschalter zugeordnet ist. Der Gruppe von Highside-Schaltern U_{H}, V_{H} und W_{H} sind also die Komparatoren KU_{H}, KV_{H} und KW_{H} zugeordnet, die gemeinsam über einen Digital-Analog-Wandler DA_{H} einen digitalen Referenzwert Ref(HS) erhalten, gegen den der Strom verglichen wird. In gleicher Weise sind den drei Lowside-Schaltern U_{L}, V_{L} und W_{L} jeweils ein separater Komparator KU_{L}, KV_{L} und KW_{L} zugeordnet, die wiederum über einen gemeinsamen Digital-Analog-Wandler DA_{L} einem digitalen Referenzwert Ref(LS) zugeführt wird, gegenüber dem der Strom verglichen wird. Eine Steuereinheit SE steuert die Digital-Analog-Wandler DA_{H} und DA_{L} an. Auch die Highside-Schalter bzw. die Lowside-Schalter werden, jeweils gruppenweise gemeinsam von der Steuereinheit SE angesteuert. Die Steuereinheit SE erhält über die Ausgänge der Kondensatoren Signale, die gegebenenfalls einen Überstrom durch einen der Schalter anzeigen. Die Referenzen Ref(HS) und Ref(LS) werden bei jedem Einschalten der Treiber auf ihren üblichen Kurzschlusserkennungswert gesetzt, um niederohmige Kurzschlüsse wie üblich erkennen zu können.

Die Digital-Analog-Wandler DA_{H} und DA_{L} werden nachfolgend zusammen mit den Überstromkomparatoren KU_{H}, KV_{H}, KW_{H} KU_{L}, KV_{L} und KW_{L} mit den Ausgangssignalen OC(x) als Strommesseinrichtungen genutzt. Zu einem geeigneten Messzeitpunkt, wie vorher beschrieben, werden die Referenzen vom Betrag her sukzessive reduziert. Der Wert Ref(HS) oder Ref(LS), der dann früher oder später zum Auslösen eines Komparators OC(x) führt, wird als Strommesswert weiterverarbeitet. Es erfolgt dabei keine Treiberabschaltung, aber umgekehrt nach Auslösen des Komparators wird wieder die übliche Überstromschwelle (Kurzschlussschutz) an Ref(HS) bzw. Ref(LS) aktiviert. Sollte also während der Reduktion der Schwelle ein Kurzschluss auftauchen, würde
a) umgehend der betreffende Komparator ausgelöst,
b) umgehend auf die normale Kurzschlusserkennungsschwelle umgeschaltet und
c) nachfolgend eine Kurzschlussabschaltung erfolgen.

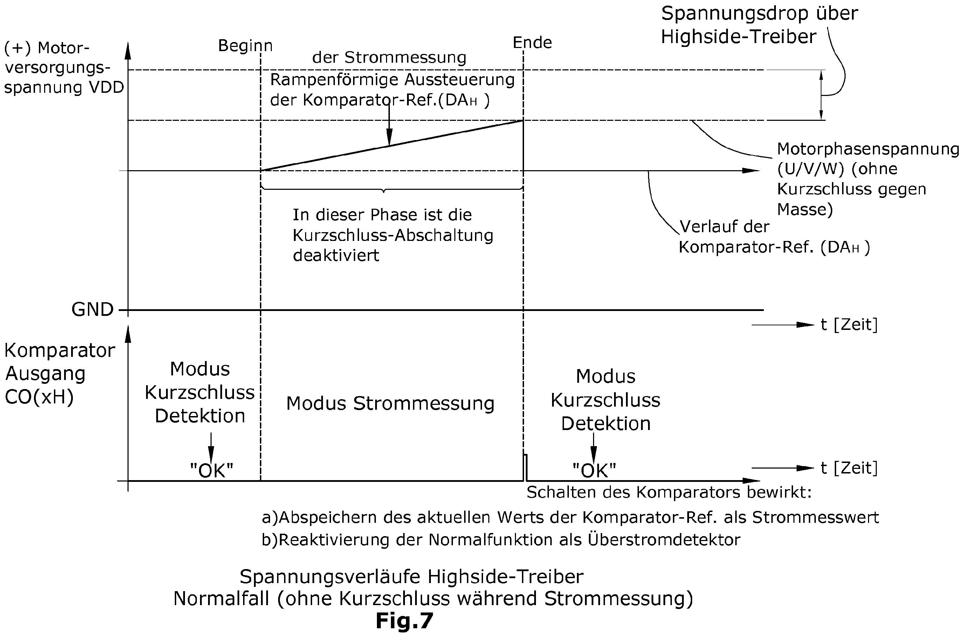

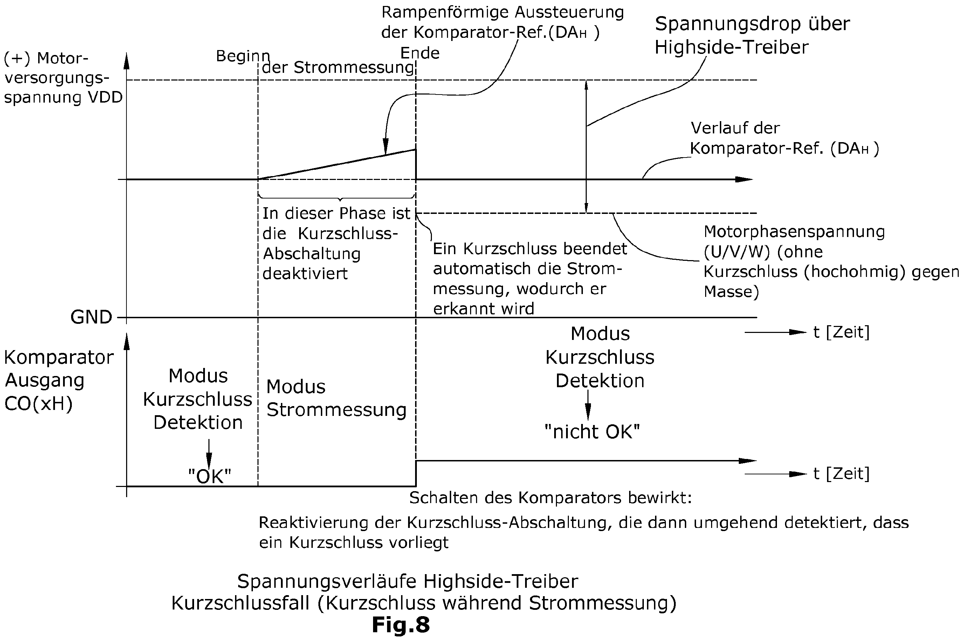

Dies ist in den Fign. 7 und 8 für den Fall, dass während der Strommessung kein Kurzschluss auftritt (Fig. 7) und für den Fall, dass während der Strommessung ein Kurzschluss eintritt (Fig. 8) nochmals graphisch am Beispiel von Spannungsverläufen an einem High Side Treiber gezeigt.

Das beschriebene Verfahren erfordert von seinen Komponenten eine ausreichende Dynamik, damit die Verzögerungen im Kurzschlussfall nicht unzulässig hoch sind. Der Vorteil der Nutzung der Überstromüberwachungseinrichtungen zur Strommessung (siehe die Fign. 6 bis 8) ist in der Kosteneinsparung durch Doppelnutzung vorhandener Bauelemente bei gleichzeitig unterbrechungsfreier Überstromüberwachung zu sehen. Eine bevorzugte Ausführungsvariante für die Änderung der Schaltschwellen der Komparatoren der Überstromüberwachungseinrichtungen ist in einem Generator für den jeweiligen Referenzwert zu sehen, der innerhalb der abfallenden Rampe eine einem Logarithmus angenäherte Funktionalität derart enthält, dass sich der Referenzwert von einem Schritt zum nächsten um einen gewissen prozentualen Wert verringert. Die Vorteile dieser Vorgehensweise sind, dass die Rampe bei gleicher relativer Genauigkeit deutlich schneller durchfahren werden kann, was eine Messung mit kleineren Duty-Cycle-Zeiten ermöglicht. Die Anzahl auszuwertender Bits pro Messwert verringert sich drastisch. Die "Punktrechnung", die die Ermittlung der Stromverhältnisse üblicherweise erfordert, kann wegen der Logarithmusbildung durch eine "Strichrechnung" nachgebildet werden. Eine kostensparende Umsetzung der Auswertung entweder durch eine kleinere Logik oder durch eine CPU-Arbeitszeit sparende Realisierung in einem Controller ist möglich.

## Patentansprüche

1. Verfahren zur Erlangung eines Hinweises, insbesondere Anfangshinweises auf eine mögliche fehlerhafte Lastbedingung eines mehrphasigen Elektromotors mit elektrischer Kommutierung mit einer Ansteuereinheit, die pro Motorphase einen Highside-Schalter und einen Lowside-Schalter aufweist, wobei die Highside- und die Lowside-Schalter der Motorphasen zyklisch geschaltet werden, und zwar gemäß einem Schaltschema, das pro Motorphase mindestens einen zyklisch wiederkehrenden äquivalenten Zeitpunkt aufweist, wobei diese äquivalenten Zeitpunkte zwischen den einzelnen Motorphasen einen gleichen zeitlichen Phasenversatz aufweisen und wobei zu diesen Zeitpunkten jeweils die Größe des Stroms in der betreffenden Motorphase jeweils in einem im Wesentlichen gleichen Verhältnis zu den Größen der Ströme in den anderen Motorphasen zu den diesen anderen Motorphasen zugehörigen äquivalenten Zeitpunkten steht, wobei bei dem Verfahren
- für zumindest zwei Motorphasen zu den zyklisch wiederkehrenden äquivalenten Zeitpunkten des Schaltschemas ein die Größe des Stroms in der betreffenden Motorphase repräsentierender Messwert ermittelt wird und dieser Vorgang sich zyklisch wiederholend durchgeführt wird,
- die ermittelten Messwerte der Motorphasen zumindest paarweise miteinander verglichen werden, wobei jeder Vergleich der Messwerte dahingehend überprüft wird, ob sich das Ergebnis des Vergleiches innerhalb eines hinsichtlich der zu vergleichenden Motorphasen für fehlerfreie Lastbedingungen geltenden Erwartungsraumes befindet und wobei
- eine Abweichung des Ergebnisses des Vergleiches vom zugehörigen Erwartungsraum oder vom zugehörigen Erwartungsraum inklusive unter Berücksichtigung einer vorgebbaren zulässigen Toleranz als ein Hinweis auf eine fehlerbehaftete Lastbedingung gewertet wird, wobei die Wiederholrate gleichartiger sequentiell auftretender Abweichungen eine Aussage über den Fehlerort geben kann,
und/oder
- bedarfsweise auch die Analyse der Stromwerte mindestens einer einzigen Motorphase zu den äquivalenten Zeitpunkten in sequentieller Abfolge durchgeführt und ein Abweichen der Ergebnisse der Vergleiche von Stromwerten der mindestens einen einzigen Motorphase zu den äquivalenten Zeitpunkten vom Erwartungsraum oder vom Erwartungsraum inklusive unter Berücksichtigung einer vorgebbaren zulässigen Toleranz als ein Hinweis auf eine fehlerbehaftete Lastbedingung gewertet wird, wobei die Wiederholrate gleichartiger sequentiell auftretender Abweichungen eine Aussage über den Fehlerort geben kann,
**dadurch gekennzeichnet,**
- **dass** den Highside-Schaltern von zumindest zwei Motorphasen eine Highside-Überwachungseinheit zur Überwachung der Drain-Source-Spannungsabfälle der Highside-Schalter und/oder den Lowside-Schaltern von zumindest zwei Motorphasen eine Lowside-Überwachungseinheit zur Überwachung der Drain-Source-Spannungsabfälle der Lowside-Schalter zugeordnet ist, wobei jede Überwachungseinheit zur Ermittlung eines Messwertes verwendet wird, der die Größe des Stroms in einer Motorphase repräsentiert,
- **dass** jede der Überwachungseinheiten einen Komparator und einen Digital-Analog-Konverter zur Vorgabe eines Referenzwerts als Spannungsabfall-Schwellwert zur Detektion eines Überstromes in einem Highside- und/oder Lowside-Schalter für den Komparator aufweist und
- **dass** dieser Referenzwert moduliert wird, um einen die Größe des aktuellen Stroms repräsentierenden Messwert mittels Auswertung des Komparators zu ermitteln, wobei ein während der Ermittlung des Messwerts auftretendes Ansprechen des Komparators nicht direkt als Überstrom gewertet wird, sondern in diesem Fall die Ermittlung des Messwerts abgeschlossen wird und im Anschluss die Referenz des Digital-Analog-Konverters auf den eigentlichen Überstromwert geschaltet wird und nachfolgend eine tatsächliche Bewertung, ob eine Überstromsituation aufgetreten ist, durchgeführt wird.

2. Verfahren nach Anspruch 1, **dadurch gekennzeichnet, dass** die Modifizierung des Referenzwertes beim Referenzwert zur Detektion eines Überstromes beginnt und zu geringeren Beträgen fortgesetzt wird wobei für die Bestimmung des zu ermittelnden Messwertes der Komparator nur einmal am Ende der Reduktion anspricht.

3. Verfahren nach Anspruch 2, **dadurch gekennzeichnet, dass** die Verringerung des Betrages des Referenzwertes nicht linear sondern in logarithmisch angenäherten Stufen erfolgt, in der Art, dass die prozentuale Reduktion von einem Betrag zum nächsten annähernd gleich ist.

4. Verfahren nach Anspruch 1, **dadurch gekennzeichnet, dass** die Modulation des Referenzwertes gemäß einer sukzessiven Approximation erfolgt, wobei bei jedem Ansprechen des Komparators die Ermittlung des Messwertes unterbrochen wird, um eine Überprüfung auf eine mögliche Überstromsituation einzuschieben.

5. Verfahren nach einem der Ansprüche 1 bis 4, **dadurch gekennzeichnet, dass** aus der Motorphasenpaarung oder -kombination, für die eine Abweichung außerhalb des Erwartungsraumes festgestellt wird, und der Position der zugehörigen äquivalenten Zeitpunkte innerhalb des Schaltschemas auf die Art der fehlerhaften Lastbedingung geschlossen wird, für die die Abweichung als ein Hinweis, insbesondere als Anfangshinweis gewertet wird.

6. Verfahren nach einem der Ansprüche 1 bis 5, **dadurch gekennzeichnet, dass** ein detektierter Anfangshinweis auf eine mögliche fehlerhafte Lastbedingung auf zeitliche Wiederholung hin untersucht und bei zumindest zyklisch kontinuierlichem Wiederholen ab einer vorgebbaren Häufigkeit eine fehlerhafte Lastbedingung diagnostiziert wird.

7. Verfahren nach einem der Ansprüche 1 bis 6, **dadurch gekennzeichnet, dass** dann, wenn bei einem fehlerfreien System mit zumindest Elektromotor und Ansteuereinheit ein zyklisch reproduzierbarer Hinweis auf eine fehlerhafte Lastbedingung detektiert wird, dieser Hinweis nicht auf eine tatsächliche fehlerhafte Lastbedingung, sondern auf eine elektrische und/oder mechanische Asymmetrie zwischen den Motorphasen zumindest einer der Systemkomponenten wie z.B. Ansteuereinheit und/oder Motormechanik und/oder Getriebe und/oder ein anderes vom Elektromotor angetriebenes Bauteil zurückzuführen ist, und dieses in zukünftig vorgebbaren Erwartungswertbereichen für ein fehlerfreies System berücksichtigt wird.

8. Verfahren nach einem der Ansprüche 1 bis 7, **dadurch gekennzeichnet, dass** dann, wenn bei einem fehlerfreien System mit zumindest Elektromotor und Ansteuereinheit ein zyklisch reproduzierbarer Hinweis auf eine fehlerhafte Lastbedingung detektiert wird, dieser Hinweis nicht auf eine tatsächliche fehlerhafte Lastbedingung, sondern auf eine elektrische und/oder mechanische Asymmetrie zwischen den Motorphasen zumindest einer der Systemkomponenten wie z.B. Ansteuereinheit und/oder Motormechanik und/oder Getriebe und/oder ein anderes vom Elektromotor angetriebenes Bauteil zurückzuführen ist, und diese Asymmetrie zur Erlangung verbesserter Systemeigenschaften über eine Modifikation des Schaltschemas kompensiert wird.

9. Verfahren nach einem der Ansprüche 1 bis 8, **dadurch gekennzeichnet, dass** der Hinweis auf eine fehlerhafte Lastbedingung eine Folge des Abweichen des Kommutierungswinkels von seinem Sollwert ist und in diesem Fall die Ansteuereinheit den Fehler durch Anpassung zumindest eines der Ansteuerparameter Amplitude und Phase und Drehfrequenz kompensiert.

10. Verfahren nach einem der Ansprüche 1 bis 9, **dadurch gekennzeichnet, dass** im Falle eines dreiphasigen Elektromotors derjenige Zeitpunkt, zu dem zumindest an einer Motorphase der Messwert ermittelt wird, gleich dem Zeitpunkt ist, zu dem der Strom in einer anderen Motorphase zu Null detektiert wird.

11. Verfahren nach einem der Ansprüche 1 bis 10, **dadurch gekennzeichnet, dass** der den Strom repräsentierende Messwert ein Spannungsabfall ist und dass zur Ermittlung des Ergebnisses des Vergleiches zweier Messwerte Differenzen und/oder Absolutwerte von einzelnen Spannungsabfällen auf geschalteten Kapazitäten abgelegt werden und mittels zumindest eines Verfahrens aus der Gruppe der nachfolgend genannten Verfahren behandelt und/oder ausgewertet werden: Verstärkung, Stapelung von zeitlich sequentiellen Messwerten, Vergleich, Differenzbildung, Filterung, AD-Wandlung.

## Claims

1. A method for obtaining an indication, in particular an initial indication, of a possible faulty load condition of a multi-phase electric motor with electric commutation having a drive unit which, per motor phase, comprises a high-side switch and a low-side switch, wherein the high-side and low-side switches of the motor phases are cyclically switched according to a switching scheme which, per motor phase, comprises at least one cyclically recurrent equivalent time point, wherein these equivalent time points have, between the individual motor phases, an identical temporal phase shift, and wherein, at these time points, the respective amount of the current in the respective motor phase is each time in a substantially identical relation to the amounts of the currents in the other motor phases at the equivalent time points appertaining to these other motor phases, wherein, in said method,
- for at least two motor phases, at the cyclically recurrent equivalent time points of the switching scheme, a measurement value is detected which represents the amount of the current in the respective motor phase and this process is performed in a cyclically repetitive manner,
- the detected measurement values of the motor phases are compared to each other at least in pairs, wherein each comparison of the measurement values is examined as to whether the result of the comparison is within an expectation range which is valid with respect to the to-be-compared motor phases for fault-free load conditions, and wherein
- a deviation of the result of the comparison from the appertaining expectation range or from the appertaining expectation range inclusive of consideration of a presettable allowable tolerance, is evaluated as being an indication of a faulty load condition, wherein the repetition rate of similar, sequentially occurring deviations can provide a conclusion on the site of the malfunction,
and/or
- optionally, also the analysis of the current values of at least one motor phase is performed, at the equivalent time points, in sequential succession and a deviation of the results of the comparisons of current values, existing at the equivalent time points, of the at least one single motor phase from the expectation range or from the expectation range inclusive of consideration of a presettable allowable tolerance, is evaluated as being an indication of a faulty load condition, wherein the repetition rate of similar, sequentially occurring deviations can provide a conclusion on the site of the malfunction, **characterized in**
- **that** the high-side switches of at least two motor phases have assigned to them a high-side monitoring unit for monitoring the drain-source voltage drops of the high-side switches and/or that the low-side switches of at least two motor phases have assigned to them a low-side monitoring unit for monitoring the drain-source voltage drops of the low-side switches, wherein each monitoring unit is used for detection of a measurement value which represents the magnitude of a current in a motor phase,
- **that** each of the monitoring units comprises a comparator and a digital/analog converter for presetting a reference value as a voltage-drop threshold value for detecting an overcurrent in a high-side and/or low-side switch for the comparator, and
- **that** this reference value is modulated for detecting, by evaluation of the comparator, a measurement value representing the amount of the present current, wherein a response of the comparator occurring during the detecting of the measurement value is not directly evaluated as indicating an overcurrent but, in this case, the detection of the measurement value is concluded and, subsequently, the reference of the digital/analog converter is switched to the actual overcurrent value and, then, a real evaluation is performed as to whether an overcurrent situation has occurred.

2. The method according to claim 1, **characterized in that** the modifying of the reference value starts at the reference value for detection of an overcurrent and is continued toward lower amounts, wherein, for determining the measurement value which is to be detected, the comparator is operative to respond only once at the end of the reduction.

3. The method according to claim 2, **characterized in that** the reduction of the amount of the reference value is performed not linearly but in logarithmically approximated steps in such a manner that the percentaged reduction is approximately equal from one amount to the next.

4. The method according to claim 1, **characterized in that** the modulation of the reference value is performed according to a successive approximation, wherein, upon each response of the comparator, the detection of the measurement value is interrupted so as to insert an examination for a possible overcurrent situation.

5. The method according to any one of claims 1 to 4, **characterized in that**, from the motor phase pairing or motor phase combination for which a deviation outside the expectation range is detected, and from the position of the appertaining equivalent time points within the switching scheme, a conclusion is drawn on the type of the faulty load condition for which the deviation is evaluated as an indicator, particularly an initial indicator.

6. The method according to any one of claims 1 to 5, **characterized in that** a detected initial indicator of a possible faulty load condition is examined for temporal repetition and, in case of at least cyclically continuous repetition, a faulty load condition is concluded to exist when a presettable frequency is exceeded.

7. The method according to any one of claims 1 to 6, **characterized in that**, when, in a fault-free system comprising at least an electric motor and a drive unit, a cyclically reproducible indication of a faulty load condition is detected, this indication is not attributable to a real faulty load condition but to an electrical and/or mechanical asymmetry between the motor phases of at least one of the system components such as e.g. the drive unit and/or the motor mechanics and/or the transmission and/or another component part driven by the electric motor, and this asymmetry is considered in future presettable expectation value ranges for a fault-free system.

8. The method according to any one of claims 1 to 7, **characterized in that**, when, in a fault-free system comprising at least an electric motor and a drive unit, a cyclically reproducible indication of a faulty load condition is detected, this indication is not attributable to a real faulty load condition but to an electrical and/or mechanical asymmetry between the motor phases of at least one of the system components such as e.g. the drive unit and/or the motor mechanics and/or the transmission and/or another component part driven by the electric motor, and this asymmetry is compensated, via modulation of the switching scheme, for obtaining improved system properties.

9. The method according to any one of claims 1 to 8, **characterized in that** the indication of a faulty load condition is a result of the deviation of the commutation angle from its desired value and, in this case, the drive unit is operative to compensate for the error by adapting at least one of the drive parameters amplitude and phase and rotational frequency.

10. The method according to any one of claims 1 to 9, **characterized in that**, in case of a three-phase electric motor, that time point where the measurement value is detected at least at one motor phase is identical with the time point where, at another motor phase, a zero current is detected.

11. The method according to any one of claims 1 to 10, **characterized in that** the measurement value representing the current is a voltage drop and that, for detection of the result of the comparison of two measurement values, differences and/or absolute values of individual voltage drops are applied to switched capacitances, and are treated and/or evaluated by means of at least one method from the group of the methods mentioned hereunder: amplification, stacking of temporally sequential measurement values, comparison, difference formation, filtration, A/D conversion.

## Revendications

1. Procédé d'obtention d'une indication, en particulier d'une indication initiale sur une condition de charge possible erronée d'un moteur électrique multiphasé à commutation électrique doté d'une unité de commande, laquelle comporte un commutateur côté alimentation et un commutateur côté masse par phase moteur, dans lequel les commutateurs côté alimentation et côté masse des phases moteur sont commutés de manière cyclique, à savoir selon un schéma de commutation comportant par phase moteur au moins un instant équivalent se répétant cycliquement, dans lequel ces instants équivalents comportent un même déphasage temporel entre les phases moteur individuelles et dans lequel à ces instants la grandeur respective du courant dans la phase moteur concernée est respectivement dans une proportion sensiblement égale aux grandeurs des courants dans les autres phases moteur aux instants équivalents associés à ces autres phases moteur, dans lequel lors du procédé
- pour au moins deux phases moteur, une valeur de mesure représentant la grandeur du courant dans la phase moteur concernée est déterminée aux instants équivalents se répétant cycliquement du schéma de commutation et cette opération est effectuée à répétition de manière cyclique,
- les valeurs de mesure déterminées des phases moteur sont comparées l'une à l'autre au moins par paires, dans lequel il est vérifié à chaque comparaison des valeurs de mesure si le résultat de la comparaison se trouve à l'intérieur d'un espace attendu valable pour des conditions de charge non erronées par rapport aux phases moteur à comparer et dans lequel
- une déviation du résultat de la comparaison par rapport à l'espace attendu associé ou par rapport à l'espace attendu associé y compris en prenant en compte une tolérance admise pouvant être prédéfinie est considérée comme une indication sur une condition de charge erronée, dans lequel la fréquence de répétition de déviations de même type survenant de manière séquentielle peut donner une indication sur le lieu de l'erreur.
et/ou
- l'analyse des valeurs de courant d'au moins une phase moteur individuelle est également effectuée sur demande de manière séquentielle aux instants équivalents et une déviation des résultat des comparaisons des valeurs de courant de l'au moins une phase moteur individuelle aux instants équivalents par rapport à l'espace attendu associé ou par rapport à l'espace attendu associé y compris en prenant en compte une tolérance admise pouvant être prédéfinie est considérée comme une indication sur une condition de charge erronée, dans lequel la fréquence de répétition de déviations de même type survenant de manière séquentielle peut donner une indication sur le lieu de l'erreur, **caractérisé**
- **en ce qu'**une unité de contrôle côté alimentation destinée à contrôler les chutes de tension drain-source des commutateurs côté alimentation est associée aux commutateurs côté alimentation d'au moins deux phases moteur et/ou une unité de contrôle côté masse destinée à contrôler les chutes de tension drain-source des commutateurs côté masse est associée aux commutateurs côté masse d'au moins deux phases moteur, dans lequel chaque unité de contrôle est utilisée pour déterminer une valeur de mesure qui représente la grandeur du courant dans une phase moteur,
- **en ce que** chacune des unités de contrôle comporte un comparateur et un convertisseur numérique-analogique pour le comparateur, destiné à prédéfinir une valeur de référence comme valeur seuil de chute de tension pour la détection d'une surintensité dans un commutateur côté alimentation et/ou côté masse et
- **en ce que** cette valeur de référence est modulée afin de déterminer une valeur de mesure représentant la grandeur du courant actuel au moyen d'une évaluation du comparateur, dans lequel une réponse du comparateur survenant pendant la détermination de la valeur mesurée n'est pas directement considérée comme une surintensité, mais la détermination de la valeur mesurée est dans ce cas terminée et la référence du convertisseur numérique-analogique est ensuite commutée sur la valeur de surintensité proprement dite et une évaluation réelle est ensuite effectuée pour savoir si une situation de surintensité s'est produite.

2. Procédé selon la revendication 1, **caractérisé en ce que** la modification de la valeur de référence commence à la valeur de référence pour la détection d'une surintensité et se poursuit à des valeurs plus faibles, dans lequel le comparateur ne répond qu'une fois à la fin de la réduction pour la détermination de la valeur de mesure à déterminer.

3. Procédé selon la revendication 2, **caractérisé en ce que** la réduction de la valeur de la valeur de référence n'est pas linéaire mais s'effectue par étapes approchées de manière logarithmique, de telle sorte que la réduction en pourcentage est approximativement la même d'une valeur à la suivante.

4. Procédé selon la revendication 1, **caractérisé en ce que** la modulation de la valeur de référence s'effectue selon une approximation successive, dans lequel la détermination de la valeur mesurée est interrompue à chaque réponse du comparateur afin d'intercaler une vérification d'une possible situation de surintensité.

5. Procédé selon l'une des revendications 1 à 4, **caractérisé en ce que** le type de condition de charge erronée pour laquelle l'écart est considéré comme une indication, en particulier une indication initiale, est déduit à partir de l'appariement ou de la combinaison de phases moteur pour lequel une déviation hors de l'espace attendu est établie et de la position des instants équivalents associés à l'intérieur du schéma de commutation.

6. Procédé selon l'une des revendications 1 à 5, **caractérisé en ce qu'**une répétition dans le temps est cherchée dans un indication initiale détectée sur une condition de charge erronée possible et une condition de charge erronée est diagnostiquée en cas de répétition continue au moins cyclique à partir d'une fréquence pouvant être prédéfinie.

7. Procédé selon l'une des revendications 1 à 6, **caractérisé en ce que** si, dans un système sans erreur avec au moins un moteur électrique et une unité de commande, une indication reproductible de manière cyclique d'une condition de charge erronée est détectée, cette indication n'est pas due à une condition de charge erronée réelle, mais à une asymétrie électrique et/ou mécanique entre les phases moteur d'au moins un des composants du système, comme par exemple l'unité de commande et/ou la mécanique du moteur et/ou la transmission et/ou un autre composant entraîné par le moteur électrique, et cela est pris en compte dans des intervalles de valeurs attendues pouvant être prédéfinis à l'avenir pour un système sans erreur.

8. Procédé selon l'une des revendications 1 à 7, **caractérisé en ce que** si, dans un système sans erreur avec au moins un moteur électrique et une unité de commande, une indication reproductible de manière cyclique d'une condition de charge erronée est détectée, cette indication n'est pas due à une condition de charge erronée réelle, mais à une asymétrie électrique et/ou mécanique entre les phases moteur d'au moins un des composants du système, comme par exemple l'unité de commande et/ou la mécanique du moteur et/ou la transmission et/ou un autre composant entraîné par le moteur électrique, et cette asymétrie est compensée pour obtenir des propriétés améliorées du système par une modification du schéma de commutation.

9. Procédé selon l'une des revendications 1 à 8, **caractérisé en ce que** l'indication d'une condition de charge erronée est une conséquence de l'écart de l'angle de commutation par rapport à sa valeur de consigne et, dans ce cas, l'unité de commande compense l'erreur en adaptant au moins l'un des paramètres de commande (amplitude, phase et fréquence de rotation).

10. Procédé selon l'une des revendications 1 à 9, **caractérisé en ce que**, dans le cas d'un moteur électrique triphasé, l'instant auquel la valeur de mesure est déterminée au moins sur une phase du moteur est égal à l'instant auquel le courant est détecté comme nul dans une autre phase du moteur.

11. Procédé selon l'une des revendications 1 à 10, **caractérisé en ce que** la valeur de mesure représentant le courant est une chute de tension et **en ce que**, pour déterminer le résultat de la comparaison de deux valeurs de mesure, des différences et/ou des valeurs absolues de chutes de tension individuelles sont associées à des capacités commutées et sont traitées et/ou évaluées au moyen d'au moins un procédé choisi parmi le groupe des procédés mentionnés ci-après : amplification, superposition de valeurs de mesure en séquence chronologique, comparaison, soustraction, filtrage, conversation analogique-numérique.
